Europäisches Patentamt

European Patent Office

Office européen des brevets

(19)

(11) Publication number: **0 029 481**
A1

(12) **EUROPEAN PATENT APPLICATION**

(21) Application number: **80104215.1**

(22) Date of filing: **18.07.80**

(51) Int. Cl.³: **H 01 L 29/10**
**H 01 L 29/36, H 01 L 29/203**
**H 01 L 29/80**

(30) Priority: **26.11.79 US 97473**

(43) Date of publication of application:
**03.06.81 Bulletin 81/22**

(84) Designated Contracting States:
**DE FR GB**

(71) Applicant: **International Business Machines Corporation**

**Armonk, N.Y. 10504(US)**

(72) Inventor: **Chang, Leroy Li-Gong**
**P.O. Box 548 Manor Drive**
**Goldens Bridge, N.Y. 10526(US)**

(72) Inventor: **Esaki, Leo**
**16 Shady Lane**
**Chappaqua, N.Y. 10514(US)**

(74) Representative: **Barth, Carl O., Dipl.-Ing.**
**IBM Europäische Patentdienste Rablstrasse 24**
**D-8000 München 80(DE)**

(54) **Field effect semiconductor structure.**

(57) A metal semiconductor field effect transistor (MESFET) is provided with a laminated channel (8) consisting of alternating layers (9, 10) of two semiconductors, one having a narrow energy gap and light doping and the other having a wide energy gap and heavy doping. GaAs and GaAlAs, respectively, can be used for the alternating layers (9, 10).

EP 0 029 481 A1

./...

FIG. 1

# FIELD EFFECT SEMICONDUCTOR STRUCTURE

This invention concerns semiconductor device structures of the metal semiconductor field effect transistor (MESFET) type.

The MESFET type of device has a metal Schottky barrier type junction gate over a channel between source and drain contacts. Signals applied to the gate can operate to change current flowing in the channel between the source and drain contacts by enhancing or depleting carriers in the semiconductor of the channel. A limitation has been encountered in these structures in that efforts to increase the speed by increasing the current have encountered conflicting disadvantages. The techniques for enhancing the current have involved high impurity concentration and increase in width of the channel. The high impurity concentration, however, reduces the mobility which has the effect of offsetting the high impurity concentration for the achievement of current enhancement. It also deteriorates the integrity of the Schottky barrier gate which in turn increases the gate current and requires a very thin conductive channel region for "pinch-off" or, in other words, to be able to completely shut the device off. This makes control more difficult. A wide channel will result in an ineffective use of the substrate area (or low density) and will also produce a large associated capacitance which will slow down the speed of operation.

The limitations of these two approaches have made improvements in current handling capacity of devices difficult. Here, the invention intends to provide a remedy.

Basically, in accordance with the invention, in a MESFET structure with a Schottky barrier gate, a channel region is made up of alternate layers of two semiconductors. One layer has a wide energy gap that is heavily doped and serves as a barrier, and the other has a narrow energy gap that is lightly doped or undoped and serves for conduction. The heavily doped wide gap regions that serve as barriers give up electrons that fall into the adjacent potential wells of the narrower gap material and serve for conduction. The impurity doping and layer thicknesses are governed by the

YO 9 79 015

0029481

consideration that there are to be no conduction electrons in the barrier region. The layered channel provides a modulation conduction band edge which is superimposed on the usual Schottky barrier potential profile. The result of this is that electrons are confined in migration and the resulting conduction operates with the mobility advantages of a low impurity concentration yet with the effectiveness of a high impurity concentration. These advantages provide increased speed and frequency response.

An embodiment of the invention is described in the following and shown in the appended drawing, in which:

FIG. 1 is a view of a MESFET transistor with a Schottky barrier gate and a layered channel.

FIG. 2 is an energy band diagram showing the potential profile of the various layers in the channel.

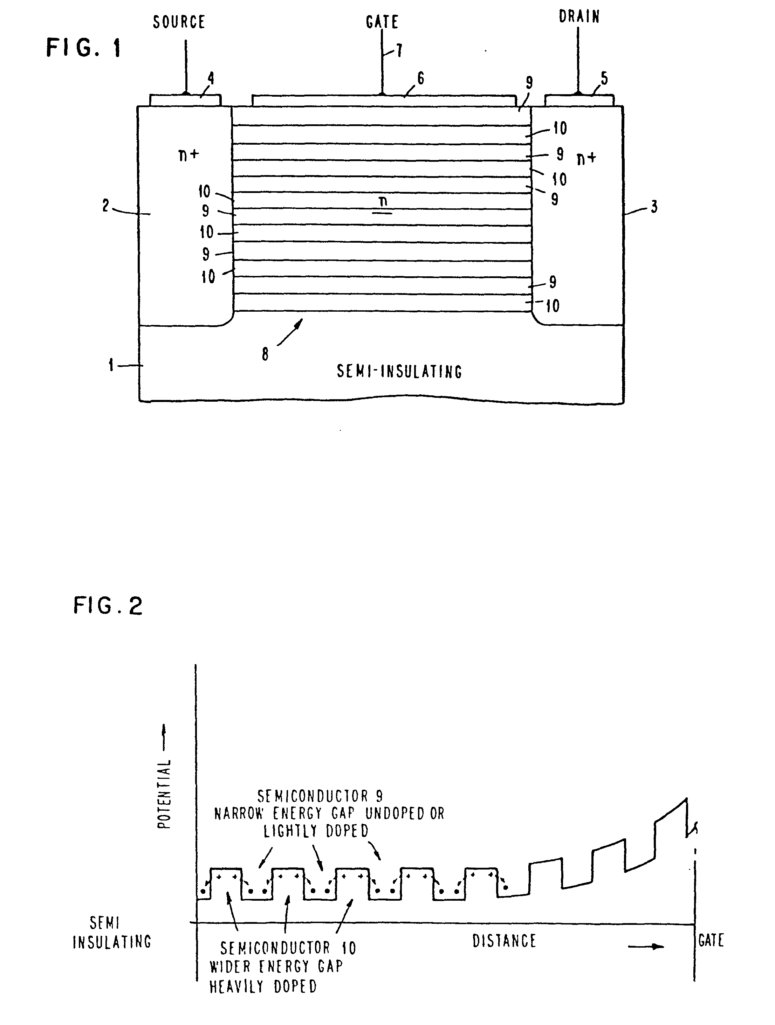

FIG. 1 shows a schematic illustration of a metal semiconductor field effect transistor (MESFET), in which on a semi-insulating substrate 1 there are provided source 2 and drain 3 regions shown, for example, as being of n+ conductivity type with electrical connections 4 and 5, respectively, to each. A Schottky barrier metal electrode 6 having an external contact 7 is provided which forms a Schottky barrier contact with the channel region, of n conductivity type, shown generally as 8 which in turn is made up of alternate layers of two semiconductors 9 and 10, respectively. The two semiconductors 9 and 10 in FIG. 1 are as follows. The semiconductor 9 has a narrower band gap and is undoped or lightly doped. Semiconductor 9 serves for conduction. The semiconductor 10 has a wider band gap and is heavily doped. Semiconductor 10 serves as a barrier.

For purposes of illustration, the description will be set forth using as examples GaAs for the narrower gap conduction semiconductor 9 and GaAlAs for the wider gap barrier semiconductor 10 and semi-insulating GaAs for the substrate. In the light of the principles of the invention it will be apparent to one skilled in the art that other semiconductors may be substituted.

The combination provides a modulated conduction band edge wherein electrons fall from donor levels in the heavily doped barrier to the adjacent potential well of the lower energy gap semiconductor. This may be seen in connection with FIG. 2 wherein an energy diagram is shown with the righthand side correlated with the contact 6. Electrons from the donor levels shown as "+" in the heavily doped barrier semiconductor 10 fall as indicated by the arrows to the lower potential level of the conduction semiconductor 9 where they are shown as ".".

In FIG. 1 the GaAlAs regions 10 are relatively heavily doped, as would be the case in an ordinary GaAs MESFET, for example, to greater than $10^{17}$ atoms per $cm^3$. The gallium arsenide regions 9 on the other hand, however, are either undoped or are lightly doped to a concentration in the vicinity of $10^{14}$ atoms per $cm^3$. The thicknesses of the individual layers 9 and 10 are not critical and are of the order of 100Å.

The total number of layers 9 and 10 is determined from considerations such as the magnitude of the "pinch-off" voltage, as is true in ordinary MESFETs.

The purpose of the layered channel illustrated in FIG. 1 is a transfer of electrons as shown in FIG. 2 from the depleted barrier regions to the accumulated well regions, or, in other words, a disassociation of carriers from their contributing impurities in the semiconductor. Such a set of conditions makes it possible to have, in the conducting gallium arsenide region of the channel 8, both the advantages of a high carrier concentration and a high mobility. Therefore, the current carrying capacity and responsiveness of a device such as shown in FIG. 1 is increased.

In operation, since the dependence of eletron mobility on temperature is much stronger for lightly doped gallium arsenide, the enhancement in mobility or current will become more pronounced at lower temperatures. As an example, using the impurity concentration set forth above, such enhancement would be about a factor of 2 at room temperature and a factor of 20 at liquid nitrogen temperature.

The individual layers of the structure with thicknesses of the order of 100Å and the alternating arrangement from gallium arsenide to gallium aluminum arsenide at specific doping densities, can be fabricated by a number of deposition techniques known in the art; molecular beam epitaxy is one of the better controlled techniques and is the preferred approach.

What has been described is a layered structure in the channel of a MESFET which operates to give in effect the advantages of high impurity density and large width while in fact having lower impurity density and better mobility and the capability of higher density of integration.

C L A I M S

1. A field effect semiconductor device with a Schottky barrier gate positioned on the surface of a channel (8) in a semiconductor body between a source and a drain electrode (4,5),
characterized in that
said channel (8) comprises a plurality of semiconductor layers (9,10) of differing energy band gaps.

2. The field effect semiconductor device of claim 1, wherein said channel (8) comprises alternating narrow and wide energy band gap layers (9,10).

3. The field effect semiconductor device of claim 2, wherein said wide energy gap layer (10) is heavily doped and serves as a barrier, whereas said narrow energy gap layer (9) is more lightly doped and serves for conduction.

4. The field effect semiconductor device of claim 3, wherein said narrow energy gap layer (9) is gallium arsenide and said wide energy gap layer (10) is gallium aluminum arsenide.

5. The field effect semiconductor device of claim 4, wherein said narrow energy gap layer (9) is doped to a concentration of about $10^{14}$ atoms per $cm^3$, and said wide emergy gap layer (10) is doped to a concentration of more than $10^{17}$ atoms per $cm^3$.

6. The field effect semiconductor device of claim 3, wherein said plurality of semiconductor layers (9,10) extend between a source and a drain region (2,3) in said semiconductor body.

7. The field effect semiconductor device of claim 6, wherein each of said semiconductor layers (9,10) is of substantially uniform thickness.

YO 9 79 015

**0029481**

8. The field effect semiconductor device of claim 7, wherein said thickness is of the order of 100Å.

9. The field effect semiconductor device of claim 4, wherein the substrate (1) of said semiconductor body is semi-insulating gallium arsenide.

FIG. 1

SOURCE          GATE          DRAIN

SEMI-INSULATING

FIG. 2

POTENTIAL

SEMICONDUCTOR 9
NARROW ENERGY GAP UNDOPED OR
LIGHTLY DOPED

SEMI
INSULATING

SEMICONDUCTOR 10
WIDER ENERGY GAP
HEAVILY DOPED

DISTANCE          GATE

European Patent Office

**EUROPEAN SEARCH REPORT**

Application number

EP 80 10 4215.1

| DOCUMENTS CONSIDERED TO BE RELEVANT | | | CLASSIFICATION OF THE APPLICATION (Int. Cl.3) |
|---|---|---|---|
| Category | Citation of document with indication, where appropriate, of relevant passages | Relevant to claim | |
| X | <u>EP - A2 - 0 005 059</u> (WESTERN ELECTRIC CO.)<br><br>* claims 1, 2, 5 to 10, 11, 13; page 2, line 33 to page 3, line 34; page 10, line 27 to page 11, line 20; page 11, line 24 to page 12, line 11; fig. 1, 2, 6 *<br><br>-- | 1-9 | H 01 L 29/10<br><br>H 01 L 29/36<br><br>H 01 L 29/203<br><br>H 01 L 29/80 |
| X | APPLIED PHYSICS LETTERS, Vol. 33, No. 7, October 1978 New York<br><br>R. DINGLE et al. "Electron Mobilities in Modulation-Doped Semiconductor Heterojunction Superlattices"<br><br>* pages 665 to 667 *<br><br>-- | | **TECHNICAL FIELDS SEARCHED (Int.Cl.3)**<br><br>H 01 L 29/06<br><br>H 01 L 29/20<br><br>H 01 L 29/36<br><br>H 01 L 29/80 |
| X,P | JAPANESE JOURNAL OF APPLIED PHYSICS, Vol. 19, No. 5, May 1980 Tokyo<br><br>T. MIMURA et al. "A New Field-Effect Transistor with Selectively Doped $GaAs/n-Al_xGa_{1-x}As$ Heterojunctions" pages L 225 to 227<br><br>* page L 225, paragraphs 1, 2; page L 226, paragraphs 4 to 6 *<br><br>--<br><br>:<br><br>./.. | | **CATEGORY OF CITED DOCUMENTS**<br><br>X: particularly relevant<br>A: technological background<br>O: non-written disclosure<br>P: intermediate document<br>T: theory or principle underlying the invention<br>E: conflicting application<br>D: document cited in the application<br>L: citation for other reasons<br><br>&: member of the same patent family, corresponding document |

| X | The present search report has been drawn up for all claims | | |
|---|---|---|---|
| Place of search<br>Berlin | Date of completion of the search<br>14-01-1981 | Examiner<br>GIBBS | |

EPO Form 1503.1   06.78

**European Patent Office**

**EUROPEAN SEARCH REPORT**

| DOCUMENTS CONSIDERED TO BE RELEVANT | | | CLASSIFICATION OF THE APPLICATION (Int. Cl.³) |
|---|---|---|---|
| Category | Citation of document with indication, where appropriate, of relevant passages | Relevant to claim | |
| | US - A - 4 137 542 (IBM)<br>* claims 1 to 3;<br>  column 1, lines 57 to 68;<br>  column 2, lines 28 to 37;<br>  fig. 1A, 1B, 2 *<br>& DE - A1 - 2 801 292 | 1,2,8 | |
| | | | **TECHNICAL FIELDS SEARCHED (Int. Cl.³)** |